# EUROPEAN PATENT SPECIFICATION

(11) **EP 4 164 109 B1**
(45) Date of publication and mention of the grant of the patent: **10.12.2025**
(21) Application number: 20940261.9
(22) Date of filing: 08.06.2020
(51) Int. Cl.: H01F 17/06, H01F 3/10, H02M 7/48, H03H 7/01, H03H 7/09

(54) **NOISE FILTER AND POWER CONVERSION DEVICE USING SAME**
RAUSCHFILTER UND LEISTUNGSWANDLERVORRICHTUNG DAMIT
FILTRE DE BRUIT ET DISPOSITIF DE CONVERSION DE COURANT UTILISANT LEDIT FILTRE DE BRUIT

(43) Date of publication of application: 12.04.2023
(73) Proprietor: MITSUBISHI ELECTRIC CORPORATION, Chiyoda-ku Tokyo 100-8310 (JP)
(72) Inventor: FUJIWARA, Hiroki, Tokyo 100-8310 (JP); KITAMURA, Tatsuya, Tokyo 100-8310 (JP)
(74) Representative: Hoffmann Eitle
(86) International application number: PCT/JP2020/022477
(87) International publication number: WO 2021/250728

(56) References cited:
- EP-A1- 3 823 164
- WO-A1-2015/098830
- WO-A1-2015/098830
- WO-A1-2018/172004
- WO-A1-2019/150859
- DE-U1- 202013 104 903
- JP-A- 2000 306 735
- JP-A- 2000 306 735
- JP-A- 2015 226 087
- JP-A- 2020 017 944
- JP-A- 2020 017 944
- US-A1- 2013 154 766
- US-A1- 2016 013 706
- US-A1- 2020 067 298
- US-A1- 2021 036 675
- US-B2- 10 660 196

## Description

### TECHNICAL FIELD

The present disclosure relates to a noise filter and a power conversion device using the same.

### BACKGROUND ART

In recent years, fuel consumption regulations for automobiles have been promoted. Accordingly, vehicles adopting idling stop in which the internal combustion engine is stopped while the vehicle is stopped, and vehicles in which the torque of the internal combustion engine is assisted by using an electric motor are increasing in number. In these vehicles, motor/generators in which an internal combustion engine and a rotary electric machine are always coupled to each other and that have a function of generating power during travel or deceleration, in addition to a starting function and a torque assist function, are becoming prevalent. From a power conversion device used in such a vehicle, electromagnetic noise occurs, and thus, a problem regarding suppression of electromagnetic noise has been posed.

A power conversion device to be used in a vehicle includes: a power conversion main circuit such as an inverter composed of a plurality of switching elements and a plurality of DC power smoothing capacitors; and a noise filter circuit. Specifically, a noise filter circuit unit that has a common mode noise suppression inductor and that is configured to reduce inductance of a circuit has been disclosed in WO 2019/064833, for example.
JP 2020 017944 A is concerned with a noise filter.
US 2020/067298 A1 is concerned with an inverter.
WO 2019/150859 A1 is concerned with a filter circuit device, and a power conversion apparatus provided with the same.
US 10 660 196 B2 is concerned with a filter comprising a printed circuit board and busbars.
DE 20 2013 104903 U1 is concerned with an EMC filter.
US 2013/154766 A1 is concerned with a feed through EMC filter.
US 2016/013706 A1 is concerned with an inverter device and an inverter-integrated electric motor.

### SUMMARY OF THE INVENTION

### PROBLEMS TO BE SOLVED BY THE INVENTION

When the noise filter circuit unit according to the above Patent Document WO2019/064833 is used, common mode noise in electromagnetic noise that occurs due to ripple voltage from the switching element can be suppressed. However, in the configuration proposed in WO2019/064833, normal mode noise cannot be suppressed, and WO2019/064833 has no description about a structure for downsizing the noise filter circuit unit. Thus, WO2019/064833 poses a problem that a noise filter is increased in size and a problem that the normal mode noise of the power conversion device is not suppressed.

Therefore, an object of the present disclosure is to obtain a downsized noise filter, and to obtain a power conversion device in which normal mode noise is suppressed.

### SOLUTION TO THE PROBLEMS

A noise filter according to the present invention is defined in claims 1, 3, and 4.

A power conversion device according to the present invention is defined in claim 12.

### EFFECT OF THE INVENTION

The noise filter according to the present disclosure includes a plurality of stages of LC filters composed of a plurality of inductors and a plurality of capacitors, and each inductor has a bus bar having a plate shape, and a core member made from a magnetic body and having a tubular shape surrounding the bus bar. Therefore, the plurality of inductors can share the bus bar being a winding portion, and the noise filter can be downsized.

In the power conversion device according to the present disclosure, the plurality of inductors of the noise filter are composed of: a specific bus bar, which is a first bus bar having a plate shape on a positive side and connecting an external power supply and the power conversion main circuit, or a second bus bar having a plate shape on a negative side and connecting the external power supply and the power conversion main circuit; and a plurality of core members surrounding the specific bus bar. The plurality of capacitors are provided between the first bus bar and the second bus bar. The plurality of stages of LC filters are provided to the first bus bar and the second bus bar which connect the external power supply and the power conversion main circuit. Therefore, normal mode noise of the power conversion device can be suppressed.

### BRIEF DESCRIPTION OF THE DRAWINGS

[FIG. 1] FIG. 1 shows a circuit configuration of a power conversion device including a noise filter according to embodiment 1 which is useful for understanding the invention.
[FIG. 2] FIG. 2 is a perspective view showing a main part of the noise filter according to embodiment 1.
[FIG. 3] FIG. 3 is a perspective view showing core members a noise filter according to embodiment 2 according to the invention.
[FIG. 4] FIG. 4 is a perspective view showing core members of a noise filter according to embodiment 3 which is useful for understanding the invention.
[FIG. 5] FIG. 5 is a perspective view showing a divided core member of a noise filter according to embodiment 4 according to the invention.
[FIG. 6] FIG. 6 is a perspective view showing a core member of a noise filter according to embodiment 5 according to the invention.
[FIG. 7] FIG. 7 is a perspective view showing a divided core member of a noise filter according to embodiment 6 according to the invention.
[FIG. 8] FIG. 8 is a perspective view showing a main part of a noise filter according to embodiment 7 which is useful for understanding the invention.
[FIG. 9] FIG. 9 is an exploded perspective view of the main part of the noise filter according to embodiment 7.
[FIG. 10] FIG. 10 is a perspective view showing a main part of a noise filter according to embodiment 8 which is useful for understanding the invention.
[FIG. 11] FIG. 11 is a perspective view showing a main part of a noise filter according to embodiment 9.
[FIG. 12] FIG. 12 is a perspective view showing bus bars of the noise filter according to embodiment 9.
[FIG. 13] FIG. 13 is a perspective view showing the main part of the noise filter according to embodiment 9.

### DESCRIPTION OF EMBODIMENTS

Hereinafter, a noise filter and a power conversion device using the same according to embodiments of the present disclosure will be described with reference to the drawings. In the drawings, the same or corresponding members or parts are denoted by the same reference characters and described. The materials, shapes, dispositions, and the like of components described in the embodiments are not intended to limit the present disclosure thereto, unless otherwise specified.

### Embodiment 1 useful for understanding the invention

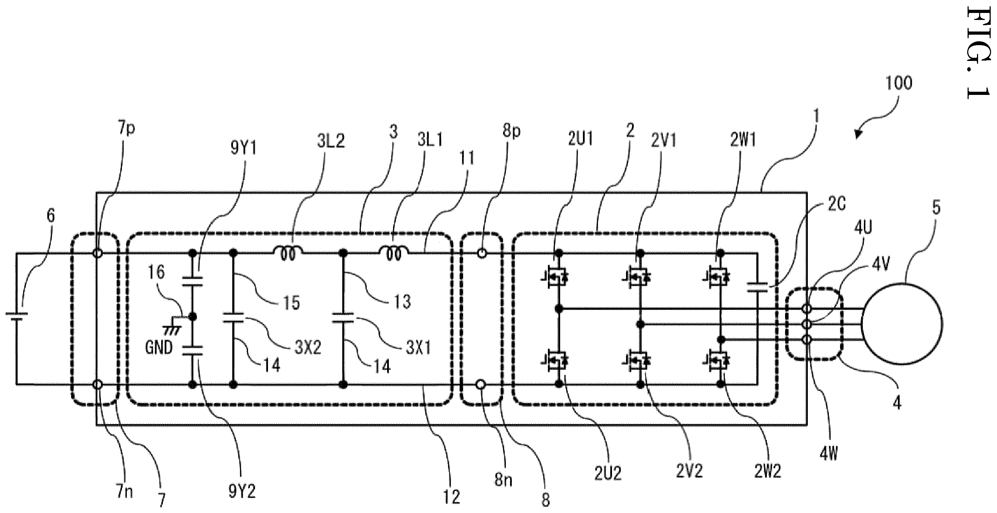

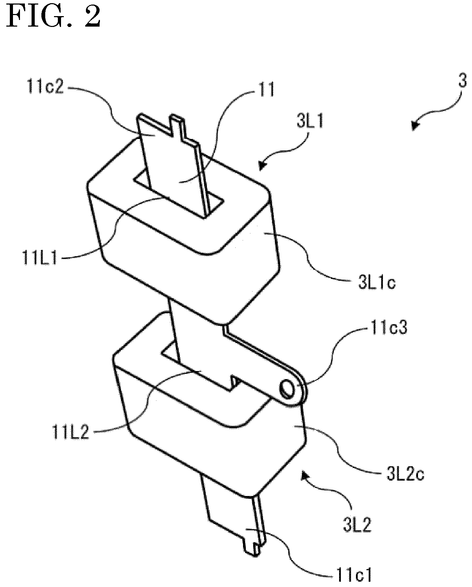

FIG. 1 shows a circuit configuration of a power conversion device 1 including a noise filter 3 according to embodiment 1. FIG. 2 is a perspective view showing a first inductor 3L1 and a second inductor 3L2 which are a main part of the noise filter 3. The power conversion device 1 is used, as an inverter device, in an inverter integrated-type rotary electric motor 100 in which an inverter device and a rotary electric machine 5 are integrated. The inverter integrated-type rotary electric motor 100 is a device that converts power supplied from a battery 6 and outputs the resultant power to the rotary electric machine 5. As shown in FIG. 1, the inverter integrated-type rotary electric motor 100 is composed of the power conversion device 1, the rotary electric machine 5, and the battery 6. The inverter integrated-type rotary electric motor 100 further includes a plurality of components. However, for simplification of description, only parts necessary for description are described and the other parts are not described. The inverter integrated-type rotary electric motor 100 according to this embodiment is suitable for an AC motor/generator that is used in drive assistance of an engine and in generation of power.

### <Power conversion device 1>

The power conversion device 1 includes: a power conversion main circuit 2 for performing conversion of power; and the noise filter 3. The noise filter 3 suppresses electromagnetic noise that occurs from the power conversion main circuit 2 during power conversion operation. The power conversion main circuit 2 and the noise filter 3 are connected to each other via a second conductor connection portion 8. The power conversion device 1 is connected to the battery 6 being an external power supply via a first conductor connection portion 7. The power conversion device 1 is connected to the rotary electric machine 5 via an AC conductor connection portion 4. The power conversion main circuit 2 converts DC power supplied from the battery 6 into AC power, and supplies the AC power to the rotary electric machine 5 via the AC conductor connection portion 4. The rotary electric machine 5 generates drive force of the engine on the basis of the supplied AC power. The rotary electric machine 5 also acts as a generator that regenerates AC power at the time of rotation by external force, to the battery 6. The rotary electric machine 5 is a brushless motor composed of three-phase windings (U phase, V phase, W phase), for example.

### <Power conversion main circuit 2>

The power conversion main circuit 2 is composed of a bridge circuit corresponding to the respective three-phase windings of U phase, V phase, and W phase of the rotary electric machine 5, and a smoothing capacitor 2C. The bridge circuit includes six power semiconductors 2U1, 2U2, 2V1, 2V2, 2W1, 2W2 which convert power, and these are metal oxide semiconductor field effect transistors (MOSFETs), for example. The source terminal of the power semiconductor 2U1 and the drain terminal of the power semiconductor 2U2 are connected to the U phase of the rotary electric machine 5 via an AC conductor connection portion 4U. The source terminal of the power semiconductor 2V1 and the drain terminal of the power semiconductor 2V2 are connected to the V phase of the rotary electric machine 5 via an AC conductor connection portion 4V. The source terminal of the power semiconductor 2W1 and the drain terminal of the power semiconductor 2W2 are connected to the W phase of the rotary electric machine 5 via an AC conductor connection portion 4W.

### <Noise filter 3>

The noise filter 3 is provided between the first conductor connection portion 7 and the second conductor connection portion 8, and suppresses electromagnetic noise that occurs from the power conversion main circuit 2. The noise filter 3 includes a plurality of stages of LC filters composed of a plurality of inductors and a plurality of capacitors. In the embodiment shown in FIG. 1, an example that includes two stages of LC filters is shown. However, the number of stages of LC filters is not limited to two, and a plurality of LC filters may further be included. The noise filter 3 includes: the first inductor 3L1, the second inductor 3L2, a first capacitor 3X1, and a second capacitor 3X2, which form the LC filters; and a first common capacitor 9Y1 and a second common capacitor 9Y2. The noise filter 3 is connected to the battery 6 via the first conductor connection portion 7, and is connected to the power conversion main circuit 2 via the second conductor connection portion 8. Since the noise filter 3 includes the plurality of stages of LC filters, the noise filter 3 can improve the attenuation characteristic of the filter. In addition, normal mode noise of the power conversion device 1 can be suppressed.

The noise filter 3 includes: a first bus bar 11 having a plate shape on the positive side and connecting the battery 6 and the power conversion main circuit 2; and a second bus bar 12 having a plate shape on the negative side and connecting the battery 6 and the power conversion main circuit 2. The first bus bar 11 connects a first positive conductor connection portion 7p of the first conductor connection portion 7 and a second positive conductor connection portion 8p of the second conductor connection portion 8. The second bus bar 12 connects a first negative conductor connection portion 7n of the first conductor connection portion 7 and a second negative conductor connection portion 8n of the second conductor connection portion 8. The first inductor 3L1 and the second inductor 3L2 are provided in series with respect to a specific bus bar, which is the first bus bar 11 or the second bus bar 12. In the present embodiment, an example in which the first bus bar 11 is assumed to be the specific bus bar and a plurality of inductors are provided to the first bus bar 11, will be shown. However, a plurality of inductors may be provided to the second bus bar 12.

The first capacitor 3X1 and the second capacitor 3X2 are provided between the first bus bar 11 and the second bus bar 12. The first capacitor 3X1 has one end thereof connected to the first bus bar 11 between the first inductor 3L1 and the second inductor 3L2, and has the other end thereof connected to the second bus bar 12 between the first negative conductor connection portion 7n and the second negative conductor connection portion 8n. The second capacitor 3X2 has one end thereof connected to the first bus bar 11 between the second inductor 3L2 and the first positive conductor connection portion 7p, and has the other end thereof connected to the second bus bar 12 between the first negative conductor connection portion 7n and the second negative conductor connection portion 8n.

The first common capacitor 9Y1 and the second common capacitor 9Y2 are connected in series at the ground potential, and both ends of the first common capacitor 9Y1 and the second common capacitor 9Y2 which are connected in series are connected in parallel to the second capacitor 3X2. The end portion of the first common capacitor 9Y1 connected in parallel to the second capacitor 3X2 is connected to the first bus bar 11 between the second inductor 3L2 and the first positive conductor connection portion 7p. The end portion of the second common capacitor 9Y2 connected in parallel to the second capacitor 3X2 is connected to the second bus bar 12 between the first negative conductor connection portion 7n and the second negative conductor connection portion 8n. Since the first common capacitor 9Y1 and the second common capacitor 9Y2 are provided, common mode noise having occurred in the power conversion main circuit 2 can be reduced.

### <Structure of noise filter 3>

A structure of the noise filter 3 which is a main part of the present disclosure will be described. As shown in FIG. 2, the first inductor 3L1 has: the first bus bar 11 having a plate shape; and a first core member 3L1c made from a magnetic body and having a quadrate and tubular shape surrounding the first bus bar 11. The second inductor 3L2 has: the first bus bar 11; and a second core member 3L2c made from a magnetic body and having a tubular shape surrounding the first bus bar 11. The first bus bar 11 is made of copper having electrical conductivity, for example. The first core member 3L1c and the second core member 3L2c are made of ferrite, for example. The first core member 3L1c and the second core member 3L2c are fixed to the first bus bar 11 via a bobbin (not shown) formed from resin, for example.

The first bus bar 11 includes: a first connection end 11c1 and a second connection end 11c2 being connection ends provided at both end portions of the first bus bar 11; and an intermediate connection end 11c3 which is drawn from a part of the first bus bar 11 between the first core member 3L1c and the second core member 3L2c provided so as to be adjacent to each other, and which is connected to one end of the first capacitor 3X1 (not shown in FIG. 2). The first connection end 11c1 is connected to the first positive conductor connection portion 7p, and the second connection end 11c2 is connected to the second positive conductor connection portion 8p.

The part of the first bus bar 11 surrounded by the first core member 3L1c is a first winding portion 11L1, and the part of the first bus bar 11 surrounded by the second core member 3L2c is a second winding portion 11L2. The first winding portion 11L1 and the second winding portion 11L2 are parts of the first bus bar 11 where current flows, and have functions as windings of the first inductor 3L1 and the second inductor 3L2. The first winding portion 11L1 and the second winding portion 11L2 have winding structures in which the first winding portion 11L1 and the second winding portion 11L2 pass once through the inner sides of the first core member 3L1c and the second core member 3L2c which each have a quadrate and tubular shape. With the structure in which the first winding portion 11L1 and the second winding portion 11L2 interlink the magnetic paths of the first core member 3L1c and the second core member 3L2c once in an equivalent manner, due to the fact that the magnetic flux density is proportional to current and the number of turns, when compared with an inductor in which a winding wound a plurality of times passes through a core member, the magnetic flux density of the core being a magnetic body can be reduced, and magnetic saturation of the magnetic body due to increase of the magnetic flux density can be prevented.

When a plurality of inductors are used in a noise filter, respective core members individually have had bus bar parts as winding portions of the inductors. However, according to the configuration shown in FIG. 2, the first inductor 3L1 and the second inductor 3L2 being two separate inductors can share the same first bus bar 11. Therefore, there is no need to connect bus bars separately provided, connection portions are not necessary, and the noise filter 3 can be downsized. In addition, the number of components can be reduced. Since a connecting step is not necessary, productivity of the noise filter 3 can be improved.

The first winding portion 11L1 and the second winding portion 11L2 are structured so as to pass through corresponding core members once. Therefore, the magnetic flux density can be reduced and iron loss such as hysteresis loss of the core members being magnetic bodies can be reduced. In addition, when compared with an inductor in which a winding wound a plurality of times passes through a core member, the conductor portion of the winding is shortened. Thus, resistance of the conductor portion of the winding can be reduced, and copper loss being a loss due to the resistance can be reduced. Therefore, heat generation at the inductor can be suppressed.

When an inductor in which a winding wound a plurality of times passes through a core member is used in a noise filter, a step of forming a winding around a core being a magnetic body has been required. However, according to the configuration shown in FIG. 2, the step of forming a winding around a core provided in an inductor can be omitted. Therefore, production cost can be suppressed, and productivity of the noise filter 3 can be improved.

As described above, the noise filter 3 according to embodiment 1 includes two stages of LC filters composed of the first inductor 3L1, the second inductor 3L2, the first capacitor 3X1, and the second capacitor 3X2. The first inductor 3L1 has the first bus bar 11 having a plate shape and the first core member 3L1c made from a magnetic body and having a tubular shape surrounding the first bus bar 11. The second inductor 3L2 has the first bus bar 11 having a plate shape and the second core member 3L2c made from a magnetic body and having a tubular shape surrounding the first bus bar 11. Therefore, the first inductor 3L1 and the second inductor 3L2 can share the first bus bar 11 being a winding portion, and the noise filter 3 can be downsized. Since the first inductor 3L1 and the second inductor 3L2 share a single first bus bar 11, connection of bus bars is not necessary, the number of components can be reduced, and productivity of the noise filter 3 can be improved.

When the first bus bar 11 includes: the first connection end 11c1 and the second connection end 11c2 being connection ends provided at both end portions of the first bus bar 11; and the intermediate connection end 11c3 which is drawn from a part of the first bus bar 11 between the first core member 3L1c and the second core member 3L2c provided so as to be adjacent to each other, and which is connected to one end of the first capacitor 3X1, there is no need to further provide a connection place between the noise filter 3 and the battery 6, a connection place between the noise filter 3 and the power conversion main circuit 2, and a connection place between the first bus bar 11 and the first capacitor 3X1. Therefore, the number of components can be reduced, and the noise filter 3 can be downsized. In addition, the noise filter 3 and the battery 6 can be easily connected to each other, the noise filter 3 and the power conversion main circuit 2 can be easily connected to each other, and productivity of the power conversion device 1 can be improved. Further, the first bus bar 11 and the first capacitor 3X1 can be easily connected to each other, and productivity of the noise filter 3 can be improved.

When the first common capacitor 9Y1 and the second common capacitor 9Y2 which are connected in series at the ground potential, and of which both ends are connected in parallel to the second capacitor 3X2 are provided, common mode noise having occurred in the power conversion main circuit 2 can be reduced.

The power conversion device 1 according to embodiment 1 includes: the power conversion main circuit 2 for performing conversion of power; and the noise filter 3. The plurality of inductors of the noise filter 3 are composed of: a specific bus bar, which is the first bus bar 11 having a plate shape on the positive side and connecting the battery 6 and the power conversion main circuit 2, or the second bus bar 12 having a plate shape on the negative side and connecting the battery 6 and the power conversion main circuit 2; and a plurality of core members surrounding the specific bus bar. The plurality of capacitors are provided between the first bus bar 11 and the second bus bar 12. The plurality of stages of LC filters are provided to the first bus bar 11 and the second bus bar 12 which connect the battery 6 and the power conversion main circuit 2.
Therefore, normal mode noise of the power conversion device 1 can be suppressed.

### Embodiment 2 according to the invention

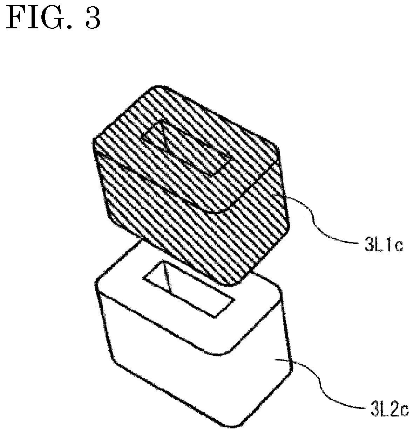

A noise filter 3 according to embodiment 2 will be described. FIG. 3 is a perspective view showing a first core member 3L1c and a second core member 3L2c of the noise filter 3 according to embodiment 2. FIG. 3 shows a first inductor 3L1 and a second inductor 3L2 which are a main part of the noise filter 3, without the first bus bar 11. The noise filter 3 according to embodiment 2 is configured to include core members of which the magnetic body materials are different from each other.

The first inductor 3L1 and the second inductor 3L2 being at least two inductors of the noise filter 3 have the first core member 3L1c and the second core member 3L2c being two core members surrounding the first bus bar 11 at positions different from each other. The magnetic body material forming the first core member 3L1c being one core member and the magnetic body material forming the second core member 3L2c being the other core member are different from each other. The different magnetic body materials are ferrite and sendust, for example. The different magnetic body materials may be ferrites that respectively have different mixing ratios of nickel or manganese.

As described above, the noise filter 3 according to embodiment 2 has a configuration in which the first inductor 3L1 and the second inductor 3L2 include core members of which the magnetic body materials are different from each other. Therefore, the noise filter 3 can have frequency characteristics that are different at the respective core members, and electromagnetic noise having a plurality of frequencies can be efficiently suppressed.

### Embodiment 3 useful for understanding the invention

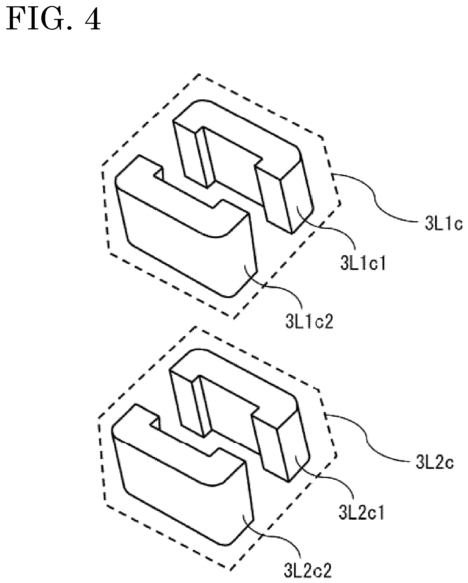

A noise filter 3 according to embodiment 3 will be described. FIG. 4 is a perspective view showing a first core member 3L1c and a second core member 3L2c of the noise filter 3 according to embodiment 3. FIG. 4 is a diagram in which the first bus bar 11 and members surrounding the first core member 3L1c and the second core member 3L2c are removed from the first inductor 3L1 and the second inductor 3L2 which are a main part of the noise filter 3. The noise filter 3 according to embodiment 3 is configured to include divided core members.

The first core member 3L1c and the second core member 3L2c are each divided. The first core member 3L1c is a core member configured by combining a first division core 3L1c1 and a second division core 3L1c2. The second core member 3L2c is a core member configured by combining a third division core 3L2c1 and a fourth division core 3L2c2. Each of the first core member 3L1c and the second core member 3L2c is integrated by being molded with resin, for example, and is integrated with and fixed to the first bus bar 11. In FIG. 4, the parts of external forms of the integrated first core member 3L1c and the integrated second core member 3L2c are indicated by broken lines.

As described above, the noise filter 3 according to embodiment 3 has a configuration in which each of the first inductor 3L1 and the second inductor 3L2 includes divided core members. Therefore, a gap can be provided between the divided cores, the magnetic resistance at the gap becomes larger than the magnetic resistance of the core being a magnetic body, and the magnetic flux density becomes lower than that of an inductor without a gap. Therefore, magnetic saturation of the core being a magnetic body can be prevented. In addition, decrease in inductance associated with increase in current flowing in the first bus bar 11 can be suppressed, and decrease in the attenuation characteristic as a filter can be suppressed also in a current region that has large current.

When a tubular core member that is not divided is used, in order to ensure insulation between the core member and a bus bar, a step of inserting the bus bar into the core member while managing the distance between the bus bar and the core is performed to assemble a noise filter. However, when the divided first core member 3L1c and the divided second core member 3L2c are used, there is no step of inserting the first bus bar 11 into the first core member 3L1c and the second core member 3L2c, and the distance between the first bus bar 11 and the divided cores can be easily managed. Thus, productivity can be improved.

### Embodiment 4 according to the invention

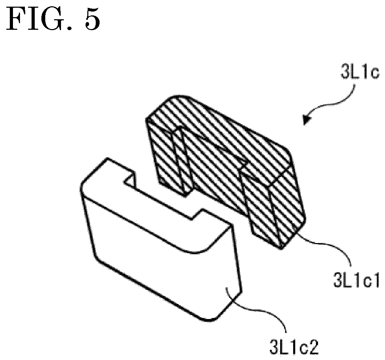

A noise filter 3 according to embodiment 4 will be described. FIG. 5 is a perspective view showing a divided first core member 3L1c of the noise filter 3 according to embodiment 4. The noise filter 3 according to embodiment 4 has a configuration in which magnetic body materials of respective divided core members are different from each other.

In the first core member 3L1c, magnetic body materials forming a first division core 3L1c1 and a second division core 3L1c2 being the respective divided core members are different from each other. The different magnetic body materials are ferrite and sendust, for example. The different magnetic body materials may be ferrites that respectively have different mixing ratios of nickel or manganese.

As described above, in the noise filter 3 according to embodiment 4, the magnetic body materials forming the first division core 3L1c1 and the second division core 3L1c2 being the respective divided core members are different from each other. Therefore, the noise filter 3 can have different frequency characteristics between the first division core 3L1c1 and the second division core 3L1c2, and electromagnetic noise having a plurality of frequencies can be efficiently suppressed.

### Embodiment 5

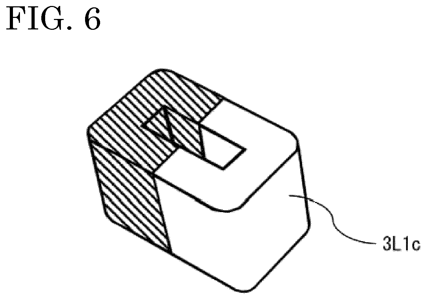

A noise filter 3 according to embodiment 5 will be described. FIG. 6 is a perspective view showing a first core member 3L1c of the noise filter 3 according to embodiment 5. The noise filter 3 according to embodiment 5 is configured to include core members made from different magnetic body materials.

The first core member 3L1c has integrated therein a plurality of different magnetic body materials. In the first core member 3L1c, two different magnetic body materials are integrated at a border which is one plane perpendicular to a plate surface of the first bus bar 11 having a plate shape not shown in FIG. 6. The place where the different magnetic body materials are integrated is not limited thereto, and, for example, may be one plane parallel to a plate surface of the first bus bar 11. The different magnetic body materials are ferrite and sendust, for example. The different magnetic body materials may be ferrites that respectively have different mixing ratios of nickel or manganese.

As described above, with respect to the noise filter 3 according to embodiment 5, in the first core member 3L1c, two different magnetic body materials are integrated at a border which is one plane perpendicular to a plate surface of the first bus bar 11 having a plate shape. Therefore, the first core member 3L1c can have different frequency characteristics with respect to this plane serving as a border, and electromagnetic noise having a plurality of frequencies can be efficiently suppressed.

### Embodiment 6 according to the invention

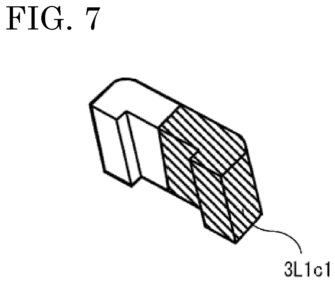

A noise filter 3 according to embodiment 6 will be described. FIG. 7 is a perspective view showing a divided core member of the first core member 3L1c of the noise filter 3 according to embodiment 6. The noise filter 3 according to embodiment 6 is configured to include a divided core member made from different magnetic body materials.

A divided first division core 3L1c1 has integrated therein a plurality of different magnetic body materials. In the first division core 3L1c1, two different magnetic body materials are integrated at a border which is one plane perpendicular to a plate surface of the first bus bar 11 having a plate shape not shown in FIG. 7. The place where the different magnetic body materials are integrated is not limited thereto. Although only the first division core 3L1c1 is formed by a plurality of different magnetic body materials being integrated, a second division core 3L1c2 may also be formed by a plurality of different magnetic body materials being integrated. The different magnetic body materials are ferrite and sendust, for example. The different magnetic body materials may be ferrites that respectively have different mixing ratios of nickel or manganese.

As described above, in the noise filter 3 according to embodiment 6, the divided first division core 3L1c1 is formed by two different magnetic body materials being integrated at a border which is one plane perpendicular to a plate surface of the first bus bar 11 having a plate shape. Therefore, the first division core 3L1c1 can have different frequency characteristics with respect to this plane serving as a border, and electromagnetic noise having a plurality of frequencies can be efficiently suppressed.

### Embodiment 7 useful for understanding the invention

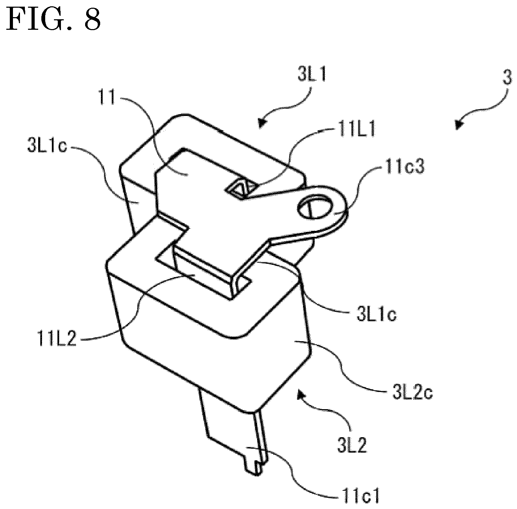

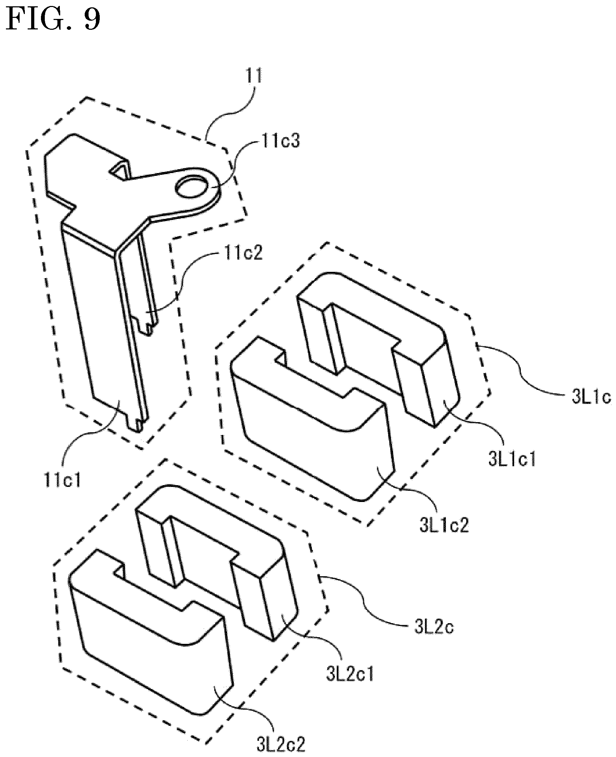

A noise filter 3 according to embodiment 7 will be described. FIG. 8 is a perspective view showing a first inductor 3L1 and a second inductor 3L2 which are a main part of the noise filter 3 according to embodiment 7. FIG. 9 is an exploded perspective view of the first inductor 3L1 and the second inductor 3L2 which are the main part of the noise filter 3. The noise filter 3 according to embodiment 7 is configured to include a first bus bar 11 that is bent in a U-shape.

The first inductor 3L1 and the second inductor 3L2 being at least two inductors of the noise filter 3 have a first core member 3L1c and a second core member 3L2c being two core members surrounding the first bus bar 11 at positions different from each other. A part of the first bus bar 11 between the first core member 3L1c and the second core member 3L2c is bent in a U-shape, and the first core member 3L1c and the second core member 3L2c are disposed so as to be adjacent to each other on the respective outer peripheral sides thereof. As shown in FIG. 9, the first bus bar 11 includes: a first connection end 11c1 and a second connection end 11c2 provided at both end portions of the first bus bar 11; and an intermediate connection end 11c3 which is drawn from a part of the first bus bar 11 between the first core member 3L1c and the second core member 3L2c provided so as to be adjacent to each other, and which is connected to one end of the first capacitor 3X1 (not shown in FIG. 9). The first connection end 11c1 is connected to the first positive conductor connection portion 7p, and the second connection end 11c2 is connected to the second positive conductor connection portion 8p.

The noise filter 3 shown in FIG. 2 has a structure in which the first inductor 3L1 and the second inductor 3L2 are arranged on one straight line on the same plane. According to the configuration shown in FIG. 8, the area of a plane occupied by the first inductor 3L1 and the second inductor 3L2 can be reduced. In a case where the structure in which the first inductor 3L1 and the second inductor 3L2 are arranged on one straight line on the same plane as in FIG. 2 cannot be adopted, and there is restriction in arrangement of components on a plane, when the configuration shown in FIG. 8 is adopted, the entire length of the first inductor 3L1, the second inductor 3L2, and the first bus bar 11 extending on a plane can be shortened, and the area of the plane occupied by these components can be reduced. In the configuration shown in FIG. 9, each of the first core member 3L1c and the second core member 3L2c has divided core members. However, the present disclosure is not limited thereto, and a configuration in which each of the first core member 3L1c and the second core member 3L2c is not divided may be adopted.

As shown in FIG. 9, in the parts of the first bus bar 11 extending from the place where the first bus bar 11 is bent in a U-shape, the directions in which the parts of the first bus bar 11 extend as well as the plate surfaces of the parts of the first bus bar 11 are parallel to each other, and the parts of the first bus bar 11 are shifted from each other in a lateral width direction. Since the first bus bar 11 is bent into a U-shape, the directions of current flowing in the first inductor 3L1 and the second inductor 3L2 become opposite to each other. Since the current directions are opposite to each other, magnetic fluxes around the first core member 3L1c and the second core member 3L2c occur in directions in which the magnetic fluxes cancel each other. When the parts of the first bus bar 11 extending from the place where the first bus bar 11 is bent in a U-shape are shifted from each other in the lateral width direction, cancelation of the magnetic fluxes can be reduced, and deterioration of filter performance of the inductors can be prevented.

As described above, in the noise filter 3 according to embodiment 7, the first inductor 3L1 and the second inductor 3L2 have the first core member 3L1c and the second core member 3L2c being two core members surrounding the first bus bar 11 at positions different from each other, a part of the first bus bar 11 between the first core member 3L1c and the second core member 3L2c is bent in a U-shape, and the first core member 3L1c and the second core member 3L2c are disposed so as to be adjacent to each other on the respective outer peripheral sides thereof. Therefore, the area of the plane occupied by the first inductor 3L1 and the second inductor 3L2 can be reduced. Since the first bus bar 11 includes the first connection end 11c1, the second connection end 11c2, and the intermediate connection end 11c3, the first bus bar 11 can be easily connected to the first positive conductor connection portion 7p, the second positive conductor connection portion 8p, and the first capacitor 3X1. Therefore, the number of components can be reduced, and productivity of the noise filter 3 can be improved.

With respect to the parts of the first bus bar 11 extending from the place where the first bus bar 11 is bent in a U-shape, in a case where the directions in which the parts of the first bus bar 11 extend as well as the plate surfaces of the parts of the first bus bar 11 are parallel to each other, and the parts of the first bus bar 11 are shifted from each other in the lateral width direction, cancelation of the magnetic fluxes occurring around the first core member 3L1c and the second core member 3L2c can be reduced, and deterioration of filter performance of the inductors can be prevented.

### Embodiment 8 useful for understanding the invention

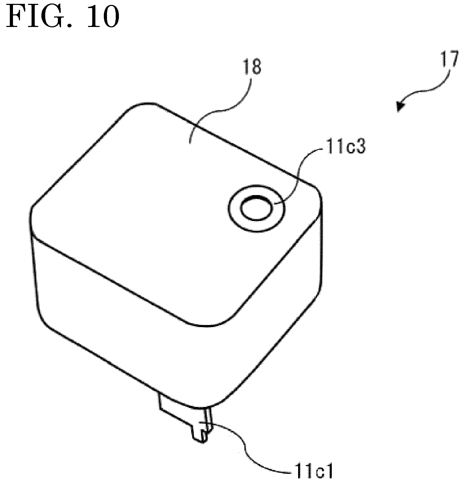

A noise filter 3 according to embodiment 8 will be described. FIG. 10 is a perspective view showing a main part of the noise filter 3 according to embodiment 8. The noise filter 3 according to embodiment 8 is molded.

As shown in FIG. 10, the first bus bar 11, the first core member 3L1c, and the second core member 3L2c shown in FIG. 8 are molded with an insulating material 18, whereby an inductor ASSY 17 is formed. The first connection end 11c1, the second connection end 11c2 (not shown in FIG. 10), and the intermediate connection end 11c3 of the first bus bar 11 are the places to be connected to the first positive conductor connection portion 7p, the second positive conductor connection portion 8p, and the first capacitor 3X1, and thus, are exposed from the insulating material 18.

When the first core member 3L1c or the second core member 3L2c vibrates due to, for example, an external factor or the like, there is a possibility that the first core member 3L1c or the second core member 3L2c comes into contact with another component, to be broken. When the first core member 3L1c or the second core member 3L2c is broken, there is a risk that inductance of the inductor that includes the broken core member decreases. When the first inductor 3L1 and the second inductor 3L2 are molded with the insulating material 18 such as a resin, the first core member 3L1c and the second core member 3L2c can be prevented from coming into contact with another component, to be damaged. In a case where a matter such as water that causes corrosion attaches to the first core member 3L1c, the second core member 3L2c, and the first bus bar 11, and these are corroded, there is a risk that inductances of the inductors that include the corroded members decrease. When the first core member 3L1c, the second core member 3L2c, and the first bus bar 11 are molded with the insulating material 18 such as a resin, attachment of a corrosion factor to the first core member 3L1c, the second core member 3L2c, and the first bus bar 11 can be prevented.

As described above, in the noise filter 3 according to embodiment 8, the first bus bar 11, the first core member 3L1c, and the second core member 3L2c are molded with the insulating material 18. Therefore, the first core member 3L1c and the second core member 3L2c can be prevented from coming into contact with another component, to be damaged. In addition, attachment of a corrosion factor to the first core member 3L1c, the second core member 3L2c, and the first bus bar 11 can be prevented.

### Embodiment 9

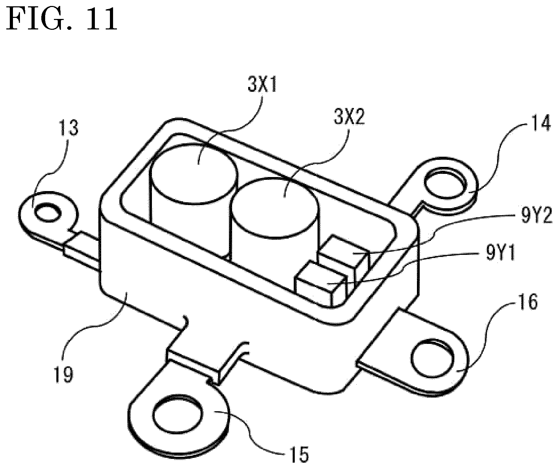

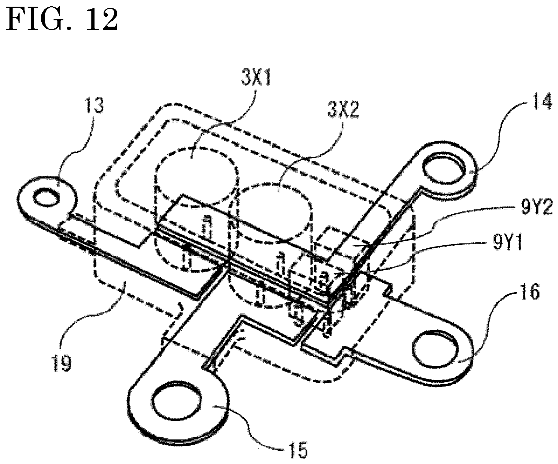

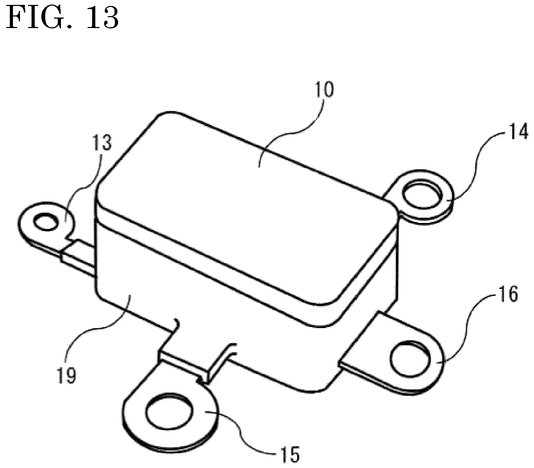

A noise filter 3 according to embodiment 9 will be described. FIG. 11 is a perspective view showing a first capacitor 3X1 and a second capacitor 3X2 which are a main part of the noise filter 3 and peripheral components of these according to embodiment 9. FIG. 12 is a perspective view showing a plurality of bus bars of the noise filter 3. FIG. 13 is a perspective view of an outer appearance showing the main part of the noise filter 3. In FIG. 12, components excluding the plurality of bus bars shown in FIG. 11 are indicated by broken lines such that the external forms of the plurality of bus bars can be seen. FIG. 11 is a diagram in which a resin-made cover 10 is removed. FIG. 13 is a diagram in which the resin-made cover 10 is mounted to a resin-made case 19. The noise filter 3 according to embodiment 9 has a configuration in which the first capacitor 3X1 and the second capacitor 3X2 are housed in the resin-made case 19.

### <First capacitor 3X1, second capacitor 3X2>

The noise filter 3 includes a first coupling bus bar 13 and a second coupling bus bar 15 which are coupling bus bars that connect one ends of the respective first capacitor 3X1 and second capacitor 3X2 and one sides of the first bus bar 11 extending to both sides from parts of the first bus bar 11 respectively surrounded by the first core member 3L1c and second core member 3L2c. As shown in FIG. 11, the first capacitor 3X1 and the second capacitor 3X2 are housed in the resin-made case 19 which is made from an insulating material and which is integrated with parts of the first coupling bus bar 13 and the second coupling bus bar 15. As shown in FIG. 13, the resin-made case 19 is covered and closed by the resin-made cover 10. The resin-made case 19 is a case in which a negative conductor connection bus bar 14 and a ground potential connection bus bar 16 are also insertmolded, in addition to the first coupling bus bar 13 and the second coupling bus bar 15.

One end of the first capacitor 3X1 is connected to the first coupling bus bar 13 with solder, and one end of the second capacitor 3X2 is connected to the second coupling bus bar 15 with solder. A part exposed from the resin-made case 19 of the first coupling bus bar 13 is connected to a part of the first bus bar 11 between the first inductor 3L1 and the second inductor 3L2, as shown in FIG. 1. A part exposed from the resin-made case 19 of the second coupling bus bar 15 is connected to a part of the first bus bar 11 between the second inductor 3L2 and the first positive conductor connection portion 7p. Since the first coupling bus bar 13 and the second coupling bus bar 15 are provided, the first capacitor 3X1 and the second capacitor 3X2 can be easily connected to the first bus bar 11. Each coupling bus bar and the first bus bar 11 may be connected to each other by screwing or the like with use of through-holes provided at end portions thereof.

The other ends of the respective first capacitor 3X1 and second capacitor 3X2 are connected with solder to the negative conductor connection bus bar 14. A part exposed from the resin-made case 19 of the negative conductor connection bus bar 14 is connected to the second bus bar 12 connected to the first negative conductor connection portion 7n and the second negative conductor connection portion 8n. Via the negative conductor connection bus bar 14 and the second bus bar 12, the other ends of the first capacitor 3X1 and the second capacitor 3X2 are connected to the first negative conductor connection portion 7n and the second negative conductor connection portion 8n.

The resin-made case 19 and the resin-made cover 10 are bonded and sealed by silicon, for example. In a case where a liquid has attached to a part between terminals of the first capacitor 3X1 or the second capacitor 3X2, a state where the first capacitor 3X1 or the second capacitor 3X2 is electrically short-circuited is established, resulting in damage of the first capacitor 3X1 or the second capacitor 3X2. Since the first capacitor 3X1 and the second capacitor 3X2 are housed while being sealed by the resin-made case 19 and the resin-made cover 10, entry of a liquid or the like into the resin-made case 19 can be prevented, and damage of the first capacitor 3X1 and the second capacitor 3X2 can be prevented. In addition, since the first capacitor 3X1 and the second capacitor 3X2 are housed in the resin-made case 19, the first capacitor 3X1 and the second capacitor 3X2 can be suppressed from being shaken due to vibration or the like and causing breakage at the terminal parts of the first capacitor 3X1 and the second capacitor 3X2.

In the present embodiment, the first capacitor 3X1 and the second capacitor 3X2 are housed, while being sealed, in the resin-made case 19. However, not limited thereto, the first capacitor 3X1 and the second capacitor 3X2, and parts of the first coupling bus bar 13 and the second coupling bus bar 15 may be molded with an insulating material. Further, the first capacitor 3X1 and the second capacitor 3X2 are provided as a plurality of capacitors, and the first capacitor 3X1 and the second capacitor 3X2 are housed, while being sealed, in the resin-made case 19. However, not limited thereto, a plurality of capacitors may further be provided, and the plurality of capacitors may be housed, while being sealed, in the resin-made case 19.

### <First common capacitor 9Y1, second common capacitor 9Y2>

The first common capacitor 9Y1 and the second common capacitor 9Y2 housed in the resin-made case 19 together with the first capacitor 3X1 and the second capacitor 3X2 will be described. The noise filter 3 includes the first common capacitor 9Y1 and the second common capacitor 9Y2 which are connected in series at the ground potential and of which both ends connected in series are connected in parallel to the second capacitor 3X2. The first common capacitor 9Y1 and the second common capacitor 9Y2 are housed in the resin-made case 19 which is made from an insulating material and which is integrated with parts of the first coupling bus bar 13, the second coupling bus bar 15, the negative conductor connection bus bar 14, and the ground potential connection bus bar 16.

One end of the first common capacitor 9Y1 is connected to the second coupling bus bar 15 with solder, and a part exposed from the resin-made case 19 of the second coupling bus bar 15 is connected to a part of the first bus bar 11 between the second inductor 3L2 and the first positive conductor connection portion 7p. The one end of the first common capacitor 9Y1 is connected to the first positive conductor connection portion 7p and the second positive conductor connection portion 8p via the second coupling bus bar 15 and the first bus bar 11. One end of the second common capacitor 9Y2 is connected to the negative conductor connection bus bar 14 with solder, and a part exposed from the resin-made case 19 of the negative conductor connection bus bar 14 is connected to the second bus bar 12 connected to the first negative conductor connection portion 7n and the second negative conductor connection portion 8n. The one end of the second common capacitor 9Y2 is connected to the first negative conductor connection portion 7n and the second negative conductor connection portion 8n via the negative conductor connection bus bar 14 and the second bus bar 12.

The other ends of the first common capacitor 9Y1 and the second common capacitor 9Y2 are connected to the ground potential connection bus bar 16 with solder, and the ground potential connection bus bar 16 is connected to the ground potential, whereby the other ends of the first common capacitor 9Y1 and the second common capacitor 9Y2 are connected to the ground potential.

Since the first common capacitor 9Y1 and the second common capacitor 9Y2 are provided, common mode noise having occurred in the power conversion main circuit 2 can be reduced. Since the first common capacitor 9Y1 and the second common capacitor 9Y2 are housed in the same resin-made case 19 in which the first capacitor 3X1 and the second capacitor 3X2 are housed, the number of components can be reduced, and the noise filter 3 can be downsized.

In a case where a liquid has attached to a part between terminals of the first common capacitor 9Y1 or the second common capacitor 9Y2, a state where the first common capacitor 9Y1 or the second common capacitor 9Y2 is electrically short-circuited is established, resulting in damage of the first common capacitor 9Y1 or the second common capacitor 9Y2. Since the first common capacitor 9Y1 and the second common capacitor 9Y2 are sealed by the resin-made case 19 and the resin-made cover 10, entry of a liquid or the like into the resin-made case 19 can be prevented, and damage of the first common capacitor 9Y1 and the second common capacitor 9Y2 can be prevented. In addition, since the first common capacitor 9Y1 and the second common capacitor 9Y2 are housed in the resin-made case 19, the first common capacitor 9Y1 and the second common capacitor 9Y2 can be suppressed from being shaken due to vibration or the like and causing breakage at the terminal parts of the first common capacitor 9Y1 and the second common capacitor 9Y2.

In the present embodiment, the first common capacitor 9Y1 and the second common capacitor 9Y2 are housed, while being sealed, in the resin-made case 19. However, not limited thereto, the first common capacitor 9Y1, the second common capacitor 9Y2, the first capacitor 3X1, and the second capacitor 3X2 may be molded with an insulating material. Further, the noise filter 3 may be combined with another filter such as a common mode choke, for example.

As described above, the noise filter 3 according to embodiment 9 includes the first coupling bus bar 13 and the second coupling bus bar 15 which connect one ends of the respective first capacitor 3X1 and second capacitor 3X2 and one sides of the first bus bar 11 extending to both sides from parts of the first bus bar 11 surrounded by the respective first core member 3L1c and second core member 3L2c. Therefore, the first capacitor 3X1 and the second capacitor 3X2 can be easily connected to the first bus bar 11, and productivity of the noise filter 3 can be improved. When these coupling bus bars and the first bus bar 11 are connected to each other by screwing with use of through-holes provided at end portions thereof, the first capacitor 3X1 and the second capacitor 3X2 can be further easily connected to the first bus bar 11. Since the first capacitor 3X1 and the second capacitor 3X2 are housed, while being sealed, in the resin-made case 19 which is made from an insulating material and which is integrated with parts of the first coupling bus bar 13 and the second coupling bus bar 15, entry of a liquid or the like into the resin-made case 19 can be prevented, and damage of the first capacitor 3X1 and the second capacitor 3X2 can be prevented. In addition, the first capacitor 3X1 and the second capacitor 3X2 can be suppressed from being shaken due to vibration or the like and causing breakage at the terminal parts of the first capacitor 3X1 and the second capacitor 3X2.

When the first common capacitor 9Y1 and the second common capacitor 9Y2 are housed in the same resin-made case 19 in which the first capacitor 3X1 and the second capacitor 3X2 are housed, the number of components of the noise filter 3 can be reduced, and the noise filter 3 can be downsized. When the first common capacitor 9Y1 and the second common capacitor 9Y2 are housed, while being sealed, in the resin-made case 19 made from an insulating material, entry of a liquid or the like into the resin-made case 19 can be prevented, and damage of the first common capacitor 9Y1 and the second common capacitor 9Y2 can be prevented. In addition, since the first common capacitor 9Y1 and the second common capacitor 9Y2 are housed in the resin-made case 19, the first common capacitor 9Y1 and the second common capacitor 9Y2 can be suppressed from being shaken due to vibration or the like and causing breakage at the terminal parts of the first common capacitor 9Y1 and the second common capacitor 9Y2.

Although the present disclosure is described above in terms of various exemplary embodiments and implementations, it should be understood that the various features, aspects, and functionality described in one or more of the individual embodiments are not limited in their applicability to the particular embodiment with which they are described, but instead can be applied, alone or in various combinations to one or more of the embodiments of the present disclosure.

It is therefore understood that numerous modifications which have not been exemplified can be devised without departing from the scope of the present disclosure. For example, at least one of the constituent components may be modified, added, or eliminated. At least one of the constituent components mentioned in at least one of the preferred embodiments may be selected and combined with the constituent components mentioned in another preferred embodiment.

### DESCRIPTION OF THE REFERENCE CHARACTERS

1 power conversion device
2 power conversion main circuit
2U1 power semiconductor
2U2 power semiconductor
2V1 power semiconductor
2V2 power semiconductor
2W1 power semiconductor
2W2 power semiconductor
2C smoothing capacitor
3 noise filter
3L1 first inductor
3L2 second inductor
3L1c first core member
3L1c1 first division core
3L1c2 second division core
3L2c second core member
3L2c1 third division core
3L2c2 fourth division core
3X1 first capacitor
3X2 second capacitor
4 AC conductor connection portion
5 rotary electric machine
6 battery
7 first conductor connection portion
7p first positive conductor connection portion
7n first negative conductor connection portion
8 second conductor connection portion
8p second positive conductor connection portion
8n second negative conductor connection portion
9Y1 first common capacitor
9Y2 second common capacitor
10 resin-made cover
11 first bus bar
11c1 first connection end
11c2 second connection end
11c3 intermediate connection end
11L1 first winding portion
11L2 second winding portion
12 second bus bar
13 first coupling bus bar
14 negative conductor connection bus bar
15 second coupling bus bar
16 ground potential connection bus bar
17 inductor ASSY
18 insulating material
19 resin-made case
100 inverter integrated-type rotary electric motor

## Claims

1. A noise filter (3) comprising
a plurality of stages of LC filters composed of a plurality of inductors (3L1, 3L2) and a plurality of capacitors (3X1, 3X2), wherein
each inductor has a bus bar (11) having a plate shape, and a core member (3L1c) made from a magnetic body and having a tubular shape surrounding the bus bar (11), and wherein
at least two of the inductors (3L1, 3L2) have two of the core members (3L1c, 3L2c) surrounding the same specific bus bar (11) at positions different from each other, **characterized in that**:
a magnetic body material forming one of the core members (3L1c) and a magnetic body material forming another of the core members (3L2c) are different from each other and have frequency characteristics that are different at the respective core members

2. The noise filter according to claim 1, wherein
the core member (3L1c1, 3L1c2, 3L2c1, 3L2c2) is divided.

3. A noise filter (3) comprising a plurality of stages of LC filters composed of a plurality of inductors (3L1, 3L2) and a plurality of capacitors (3X1, 3X2), wherein each inductor has a bus bar (11) having a plate shape, and a core member (3L1c) made from a magnetic body and having a tubular shape surrounding the bus bar (11), and wherein at least two of the inductors (3L1, 3L2) have two of the core members (3Llc, 3L2c) surrounding the same specific bus bar (11) at positions different from each other, wherein the core member (3L1c1, 3L1c2, 3L2c1, 3L2c2) is divided, **characterized in that** magnetic body materials forming the respective divided core members (3L1c1, 3L1c2, 3L2c1, 3L2c2) are different from each other and have different frequency characteristics

4. A noise filter (3) comprising a plurality of stages of LC filters composed of a plurality of inductors (3L1, 3L2) and a plurality of capacitors (3X1, 3X2), wherein each inductor has a bus bar (11) having a plate shape, and a core member (3L1c) made from a magnetic body and having a tubular shape surrounding the bus bar (11), and wherein at least two of the inductors (3L1, 3L2) have two of the core members (3Llc, 3L2c) surrounding the same specific bus bar (11) at positions different from each other, **characterized in that** the core member has integrated therein a plurality of different magnetic body materials having different frequency characteristics

5. The noise filter according to claim 4, wherein the core member is divided and wherein
the divided core member (3L1c1, 3L1c2, 3L2c1, 3L2c2) has integrated therein a plurality of different magnetic body materials.

6. The noise filter according to one of claims 1 to 5, wherein
the same specific bus bar (11) includes: connection ends (11c1, 11c2) provided at both end portions of the same specific bus bar (11); and
an intermediate connection end (11c3) which is drawn from a part of the same specific bus bar (11) between the core members (3L1c, 3L2c) provided so as to be adjacent to each other, and which is connected to the capacitor (3X1).

7. The noise filter according to one of claims 1 to 4, wherein
a part of the same specific bus bar (11) between the two core members (3L1c, 3L2c) is bent in a U-shape, and
the two core members (3L1c, 3L2c) are disposed so as to be adjacent to each other on respective outer peripheral sides thereof.

8. The noise filter according to claim 7, wherein in parts of the same specific bus bar (11) extending from a place where the bus bar (11) is bent in the U-shape, directions in which the parts of the same specific bus bar (11) extend as well as plate surfaces of the parts of the same specific bus bar (11) are parallel tc each other, and the parts of the same specific bus bar (11) are shifted from each other in a lateral width direction.

9. The noise filter according to one of claims 1 to 8, wherein
the same specific bus bar (11) and the core member (3L1c) are molded with an insulating material.

10. The noise filter according to one of claims 1 to 9, comprising
coupling bus bars (13) which connect one ends of the respective plurality of capacitors (3X1, 3X2) and one sides of the same specific bus bar (11) extending to both sides from parts of the same specific bus bar (11) respectively surrounded by the plurality of core members (3L1c, 3L2c), wherein
a part or all of the plurality of capacitors (3X1, 3X2) and a part of each coupling bus bar (13) are molded with an insulating material, or a part or all of the plurality of capacitors (3X1, 3X2) are housed, while being sealed, in a case (19) which is made from an insulating material and which is integrated with a part of the coupling bus bar (13).

11. The noise filter according to one of claims 1 to 9, comprising
a first common capacitor (9Y1) and a second common capacitor (9Y2) which are connected in series at a ground potential (16) and of which both ends are connected in parallel to the capacitor (3X1, 3X2), wherein
the first common capacitor (9Y1), the second common capacitor (9Y2), and the plurality of capacitors (3X1, 3X2) are molded with an insulating material, or are housed, while being sealed, in a case (19) which is made from an insulating material.

12. A power conversion device comprising:
a power conversion main circuit (2) for performing conversion of power; and
the noise filter (3) according to any one of claims 1 to 11, wherein
the plurality of inductors (3L1, 3L2) are composed of:
the same specific bus bar (11), which is a first bus bar (11) having a plate shape on a positive side and connecting an external power supply and the power conversion main circuit (2), or a second bus bar (12) having a plate shape on a negative side and connecting the external power supply and the power conversion main circuit (2); and
a plurality of core members (3L1c, 3L2c) surrounding the same specific bus bar (11), and
the plurality of capacitors (3X1, 3X2) are provided between the first bus bar (11) and the second bus bar (12).

## Patentansprüche

1. Rauschfilter (3), das Folgendes aufweist:
eine Vielzahl von Stufen von LC-Filtern, die aus einer Vielzahl von Induktivitäten (3L1, 3L2) und einer Vielzahl von Kondensatoren (3X1, 3X2) bestehen, wobei
jede Induktivität eine Sammelschiene (11) mit einer Plattenform und ein Kernelement (3L1c) aufweist, das aus einem magnetischen Körper hergestellt ist und eine röhrenartige Form hat, die die Sammelschiene (11) umgibt, und wobei
mindestens zwei der Induktivitäten (3L1, 3L2) zwei der Kernelemente (3L1c, 3L2c) aufweisen, die dieselbe spezifische Sammelschiene (11) an voneinander verschiedenen Positionen umgeben, **dadurch gekennzeichnet, dass**
ein magnetisches Körpermaterial, das eines der Kernelemente (3L1c) ausbildet, und ein magnetisches Körpermaterial, das ein anderes der Kernelemente (3L2c) ausbildet, voneinander verschieden sind und an den jeweiligen Kernelementen unterschiedliche Frequenzcharakteristiken aufweisen.

2. Rauschfilter nach Anspruch 1, wobei
das Kernelement (3L1c1, 3L1c2, 3L2c1, 3L2c2) geteilt ist.

3. Rauschfilter (3), das
eine Vielzahl von Stufen von LC-Filtern aufweist, die aus einer Vielzahl von Induktivitäten (3L1, 3L2) und einer Vielzahl von Kondensatoren (3X1, 3X2) bestehen,
wobei jede Induktivität eine Sammelschiene (11) mit einer Plattenform und ein Kernelement (3L1c) aufweist, das aus einem magnetischen Körper besteht und eine röhrenartige Form aufweist, welche die Sammelschiene (11) umgibt, und
wobei mindestens zwei der Induktivitäten (3L1, 3L2) zwei der Kernelemente (3L1c, 3L2c) aufweisen, die dieselbe spezifische Sammelschiene (11) an voneinander verschiedenen Positionen umgeben,
wobei das Kernelement (3L1c1, 3L1c2, 3L2c1, 3L2c2) geteilt ist, **dadurch gekennzeichnet, dass** Magnetkörpermaterialien, die die jeweiligen geteilten Kernelemente (3L1c1, 3L1c2, 3L2c1, 3L2c2) ausbilden, voneinander verschieden sind und unterschiedliche Frequenzcharakteristiken aufweisen.

4. Rauschfilter (3), das
eine Vielzahl von Stufen von LC-Filtern aufweist, die aus einer Vielzahl von Induktivitäten (3L1, 3L2) und einer Vielzahl von Kondensatoren (3X1, 3X2) bestehen, wobei jede Induktivität eine Sammelschiene (11) mit einer Plattenform aufweist, und ein Kernelement (3L1c), das aus einem magnetischen Körper hergestellt ist und eine röhrenartige Form aufweist, welche die Sammelschiene (11) umgibt, und wobei mindestens zwei der Induktivitäten (3L1, 3L2) zwei der Kernelemente (3L1c, 3L2c) aufweisen, die dieselbe spezifische Sammelschiene (11) an voneinander verschiedenen Positionen umgeben, **dadurch gekennzeichnet, dass**
das Kernelement eine Vielzahl von unterschiedlichen Magnetkörpermaterialien mit unterschiedlichen Frequenzcharakteristiken darin integriert hat.

5. Rauschfilter nach Anspruch 4, wobei
das Kernelement geteilt ist und wobei
das geteilte Kernelement (3L1c1, 3L1c2, 3L2c1, 3L2c2) eine Vielzahl von unterschiedlichen magnetischen Körpermaterialien darin integriert hat.

6. Rauschfilter nach einem der Ansprüche 1 bis 5, wobei dieselbe spezifische Sammelschiene (11) Folgendes aufweist:
Verbindungsenden (11c1, 11c2), die an beiden Endabschnitten derselben spezifischen Sammelschiene (11) vorgesehen sind; und ein Zwischenverbindungsende (11c3), das von einem Teil derselben spezifischen Sammelschiene (11) zwischen den Kernelementen (3L1c, 3L2c), die so vorgesehen sind, dass sie aneinander angrenzen, gezogen ist, und das mit dem Kondensator (3X1) verbunden ist.

7. Rauschfilter nach einem der Ansprüche 1 bis 4, wobei
ein Teil derselben spezifischen Sammelschiene (11) zwischen den beiden Kernelementen (3L1c, 3L2c) in einer U-Form gebogen ist, und
die beiden Kernelemente (3L1c, 3L2c) so angeordnet sind, dass sie aneinander an den jeweiligen äußeren Umfangsseiten angrenzen.

8. Rauschfilter nach Anspruch 7, wobei
in Teilen derselben spezifischen Sammelschiene (11), die sich von einer Stelle aus erstrecken, an der die Sammelschiene (11) in der U-Form gebogen ist, Richtungen, in denen sich die Teile derselben spezifischen Sammelschiene (11) erstrecken, sowie Plattenoberflächen der Teile derselben spezifischen Sammelschiene (11) parallel zueinander sind, und die Teile derselben spezifischen Sammelschiene (11) in einer seitlichen Breitenrichtung gegeneinander verschoben sind.

9. Rauschfilter nach einem der Ansprüche 1 bis 8, wobei
dieselbe spezifische Sammelschiene (11) und das Kernelement (3L1c) mit einem isolierenden Material ausgeformt sind.

10. Rauschfilter nach einem der Ansprüche 1 bis 9, aufweisend:
Kopplungssammelschienen (13), die ein Ende der jeweiligen Vielzahl von Kondensatoren (3X1, 3X2) und eine Seite derselben spezifischen Sammelschiene (11) verbinden, die sich zu beiden Seiten von Teilen derselben spezifischen Sammelschiene (11) erstrecken, die jeweils von der Vielzahl von Kernelementen (3L1c, 3L2c) umgeben sind, wobei
ein Teil oder alle der Vielzahl von Kondensatoren (3X1, 3X2) und ein Teil jeder Kopplungssammelschiene (13) mit einem isolierenden Material ausgeformt sind, oder ein Teil oder alle der Vielzahl von Kondensatoren (3X1, 3X2) in einem Gehäuse (19), das aus einem isolierenden Material hergestellt ist und das mit einem Teil der Kopplungssammelschiene (13) integriert ist, untergebracht sind, während sie abgedichtet sind.

11. Rauschfilter nach einem der Ansprüche 1 bis 9, aufweisend:
einen ersten gemeinsamen Kondensator (9Y1) und einen zweiten gemeinsamen Kondensator (9Y2), die mit einem Massepotential (16) in Reihe geschaltet sind und deren beide Enden mit dem Kondensator (3X1, 3X2) parallel geschaltet sind, wobei
der erste gemeinsame Kondensator (9Y1), der zweite gemeinsame Kondensator (9Y2) und die Vielzahl von Kondensatoren (3X1, 3X2) mit einem isolierenden Material ausgeformt sind oder in einem Gehäuse (19), das aus einem isolierenden Material hergestellt ist, untergebracht sind, während sie abgedichtet sind.

12. Leistungsumwandlungseinrichtung, die Folgendes aufweist:
eine Leistungsumwandlungshauptschaltung (2) zur Durchführung der Leistungsumwandlung; und
das Rauschfilter (3) nach einem der Ansprüche 1 bis 11, wobei
die Vielzahl von Induktivitäten (3L1, 3L2) zusammengesetzt sind aus:
derselben spezifischen Sammelschiene (11), die eine erste Sammelschiene (11) ist, die eine Plattenform auf einer positiven Seite aufweist und eine externe Stromversorgung und die Leistungsumwandlungshauptschaltung (2) verbindet, oder eine zweite Sammelschiene (12), die eine Plattenform auf einer negativen Seite aufweist und die externe Stromversorgung und die Leistungsumwandlungshauptschaltung (2) verbindet; und
eine Vielzahl von Kernelementen (3L1c, 3L2c), die dieselbe spezifische Sammelschiene (11) umgeben, und
die Vielzahl der Kondensatoren (3X1, 3X2) zwischen der ersten Sammelschiene (11) und der zweiten Sammelschiene (12) vorgesehen sind.

## Revendications

1. Filtre de bruit (3) comprenant :
une pluralité d'étages de filtres LC composés d'une pluralité d'inducteurs (3L1, 3L2) et d'une pluralité de condensateurs (3X1, 3X2), dans lequel
chaque inducteur présente une barre omnibus (11) présentant une forme de plaque, et un élément de noyau (3L1c) constitué d'un corps magnétique et présentant une forme tubulaire entourant la barre omnibus (11), et dans lequel
au moins deux des inducteurs (3L1, 3L2) présentent deux des éléments de noyau (3L1c, 3L2c) entourant la même barre omnibus (11) spécifique en des positions différentes l'une de l'autre, **caractérisé en ce que** :
un matériau de corps magnétique formant l'un des éléments de noyau (3L1c) et un matériau de corps magnétique formant un autre des éléments de noyau (3L2c) sont différents l'un de l'autre et présentent des caractéristiques de fréquence qui sont différentes au niveau des éléments de noyau respectifs.

2. Filtre de bruit selon la revendication 1, dans lequel
l'élément de noyau (3L1c1, 3L1c2, 3L2c1, 3L2c2) est divisé.

3. Filtre de bruit (3) comprenant une pluralité d'étages de filtres LC composés d'une pluralité d'inducteurs (3L1, 3L2) et d'une pluralité de condensateurs (3X1, 3X2), dans lequel chaque inducteur présente une barre omnibus (11) présentant une forme de plaque, et un élément de noyau (3L1c) constitué d'un corps magnétique et présentant une forme tubulaire entourant la barre omnibus (11), et dans lequel au moins deux des inducteurs (3L1, 3L2) présentent deux des éléments de noyau (3L1c, 3L2c) entourant la même barre omnibus (11) spécifique en des positions différentes l'une de l'autre, dans lequel l'élément de noyau (3L1c1, 3L1c2, 3L2c1, 3L2c2) est divisé, **caractérisé en ce que** :
les matériaux de corps magnétique formant les éléments de noyau (3L1c1, 3L1c2, 3L2c1, 3L2c2) divisés respectifs sont différents l'un de l'autre et présentent des caractéristiques de fréquence différentes.

4. Filtre de bruit (3) comprenant une pluralité d'étages de filtres LC composés d'une pluralité d'inducteurs (3L1, 3L2) et d'une pluralité de condensateurs (3X1, 3X2), dans lequel chaque inducteur présente une barre omnibus (11) présentant une forme de plaque, et un élément de noyau (3L1c) constitué d'un corps magnétique et présentant une forme tubulaire entourant la barre omnibus (11), et dans lequel au moins deux des inducteurs (3L1, 3L2) présentent deux des éléments de noyau (3L1c, 3L2c) entourant la même barre omnibus (11) spécifique en des positions différentes l'une de l'autre, **caractérisé en ce que**
l'élément de noyau a intégré dans celui-ci une pluralité de matériaux de corps magnétique différents présentant des caractéristiques de fréquence différentes.

5. Filtre de bruit selon la revendication 4, dans lequel l'élément de noyau est divisé et dans lequel
l'élément de noyau (3L1c1, 3L1c2, 3L2c1, 3L2c2) divisé a intégré dans celui-ci une pluralité de matériaux de corps magnétique différents.

6. Filtre de bruit selon l'une quelconque des revendications 1 à 5, dans lequel
la même barre omnibus (11) spécifique inclut : des extrémités de connexion (11c1, 11c2) prévues au niveau de deux portions d'extrémité de la même barre omnibus (11) spécifique ; et une extrémité de connexion intermédiaire (11c3) qui provient d'une même partie spécifique de la barre omnibus (11) entre les éléments de noyau (3L1c, 3L2c) prévus de manière à être adjacents l'un à l'autre, et qui est connectée au condensateur (3X1).

7. Filtre de bruit selon l'une quelconque des revendications 1 à 4,
dans lequel une même partie spécifique de la barre omnibus (11) entre les deux éléments de noyau (3L1c, 3L2c) est pliée dans une forme en U, et les deux éléments de noyau (3L1c, 3L2c) sont disposés de manière à être adjacents l'un à l'autre sur des côtés périphériques extérieurs respectifs de ceux-ci.

8. Filtre de bruit selon la revendication 7, dans lequel
dans des parties de la même barre omnibus (11) spécifique s'étendant à partir d'un emplacement où la barre omnibus (11) est pliée dans la forme en U, des directions dans lesquelles les parties de la même barre omnibus (11) spécifique s'étendent, ainsi que des surfaces de plaque des parties de la même barre omnibus (11) spécifique sont parallèles l'une à l'autre, et les parties de la même barre omnibus (11) spécifique sont décalées l'une par rapport à l'autre dans une direction de largeur latérale.

9. Filtre de bruit selon l'une quelconque des revendications 1 à 8, dans lequel
la même barre omnibus (11) spécifique et l'élément de noyau (3L1c) sont moulés avec un matériau isolant.

10. Filtre de bruit selon l'une quelconque des revendications 1 à 9, comprenant
des barres omnibus de couplage (13) qui connectent une extrémité de la pluralité respective de condensateurs (3X1, 3X2) et un côté de la même barre omnibus (11) spécifique s'étendant jusqu'aux deux côtés à partir de parties de la même barre omnibus (11) spécifique respectivement entourées par la pluralité d'éléments de noyau (3L1c, 3L2c), dans lequel
une partie ou la totalité de la pluralité de condensateurs (3X1, 3X2) et une partie de chaque barre omnibus de couplage (13) sont moulés avec un matériau isolant, ou une partie ou la totalité de la pluralité de condensateurs (3X1, 3X2) sont logés, tout en étant scellés, dans un boîtier (19) qui est constitué d'un matériau isolant et qui est intégré avec une partie de la barre omnibus de couplage (13).

11. Filtre de bruit selon l'une quelconque des revendications 1 à 9, comprenant
un premier condensateur commun (9Y1) et un second condensateur commun (9Y2) qui sont connectés en série au niveau d'un potentiel de terre (16) et dont les deux extrémités sont connectées en parallèle au condensateur (3X1, 3X2), dans lequel
le premier condensateur commun (9Y1), le second condensateur commun (9Y2), et la pluralité de condensateurs (3X1, 3X2) sont moulés avec un matériau isolant, ou sont logés, tout en étant scellés, dans un boîtier (19) qui est constitué d'un matériau isolant.

12. Dispositif de conversion de courant comprenant :
un circuit principal de conversion de courant (2) pour réaliser une conversion de courant ; et
le filtre de bruit (3) selon l'une quelconque des revendications 1 à 11, dans lequel
la pluralité d'inducteurs (3L1, 3L2) sont composés des éléments suivants :
la même barre omnibus spécifique (11), qui est une première barre omnibus (11) présentant une forme de plaque sur un côté positif et connectant une alimentation électrique externe et le circuit principal de conversion de courant (2), ou une seconde barre omnibus (12) présentant une forme de plaque sur un côté négatif et connectant l'alimentation électrique externe et le circuit principal de conversion de courant (2) ; et
une pluralité d'éléments de noyau (3L1c, 3L2c) entourant la même barre omnibus (11) spécifique, et
la pluralité de condensateurs (3X1, 3X2) sont prévus entre la première barre omnibus (11) et la seconde barre omnibus (12).
